# EUROPEAN PATENT APPLICATION

(11) **EP 1 819 203 A1**
(43) Date of publication of application: **15.08.2007**
(21) Application number: 05799468.3
(22) Date of filing: 21.10.2005
(51) Int. Cl.: H05B 33/22, H05B 33/14, H05B 33/10, H05B 33/12

(54) **ORGANIC ELECTROLUMINESCENCE DISPLAY PANEL AND METHOD FOR MANUFACTURING THE SAME**

(30) Priority: 28.10.2004 JP 2004314383
(71) Applicant: Pioneer Corporation, Tokyo 153-8654 (JP)
(72) Inventor: Nagayama, Kenichi, Corporate R&D, Tsurugashima-shi, Saitama 3502288 (JP)
(74) Representative: Goddar, Heinz J.
(86) International application number: PCT/JP2005/019833
(87) International publication number: WO 2006/046673

(57) **Abstract**

The present invention provides an organic electroluminescent display panel that is resistant to deterioration by outgas and to light emission problems attributable to mask contact, and a method for manufacturing this panel. The organic electroluminescent display panel includes a substrate, a first display electrode formed on the main face of the substrate and having one or more pixel light-emitting regions, an organic functional layer that is formed on the first display electrode and includes at least one organic material layer, a mask spacer provided near the organic functional layer, and a second display electrode formed on the organic functional layer. The mask spacer is made of the same material as any one of the organic material layers and has a top face located higher than the position of the second display electrode, when measured from the main face of the substrate.

## Description

### Technical Field

The present invention relates to an organic electroluminescent display panel and to a method for manufacturing the same.

### Background Art

Organic electroluminescent display panels (hereinafter referred to as organic EL display panels) whose light emission source is an organic light-emitting material having electroluminescence are known in the art. The organic EL display panels include an organic electroluminescence element (hereinafter referred to as organic EL element) formed such that an organic functional layer having a light emitting function is placed between first and second display electrodes, and a substrate that supports the organic EL element, and a plurality of the organic EL elements are arranged in a matrix, for example, on the substrate.

The organic functional layer includes a hole injection layer, hole transport layer, light emitting layer, electron transport layer, electron injection layer, and other layers. The organic functional layer can be a single layer having just a light emitting layer made of an organic compound material and having a light emitting function, for example, or can have a three-layer structure having an organic hole transport layer, a light emitting layer, and an organic electron transport layer, or a two-layer structure having an organic hole transport layer and a light emitting layer, or can be a laminate produced by inserting a carrier block or an electron or hole injection layer between a suitable pair of these layers.

With an organic EL element structured like this, when voltage is applied between the first and second display electrodes, holes and electrons are injected into the organic functional layer, and these recombine in the light emitting layer and emit light.

Methods for forming the organic functional layer and electrodes in the organic EL display panels include vapor deposition, sputtering, CVD, and other such dry processes. When an organic functional layer and electrodes are formed by one of these film formation methods, they must be formed in a suitable pattern, which is accomplished by using a mask having an opening pattern corresponding to the desired film pattern. This mask is disposed between the substrate and the thin-film material source, and acts as a blocker to block the thin-film material. As a result, a thin-film pattern corresponding to the openings in the mask is formed.

Preventing the flow of thin-film material from coming around to the back side of the mask is a key issue when high-precision patterning is performed with a mask. One of the simplest ways to solve this problem is to minimize the gap between the mask and the substrate. This requires the substrate to be brought into close contact with the mask during film formation.

However, other problems are encountered if the mask and substrate are brought too close together. Specifically, there is a limit on how completely parallel the mask can be positioned with respect to the substrate. Since the mask and substrate have roughness or undulations and are not completely flat, the mask ends up coming into contact with the organic functional layer and other thin films provided on the substrate, which can damage and foul these thin films. This leads to such problems as the formation of non-lighting pixels in a display panel.

In view of this, a technique has been proposed in which a barrier is provided protruding from a substrate, and this barrier functions as a spacer (see Japanese Patent Applications Kokai (Laid open) No. 8-227276 and No. 8-315981).

### Disclosure of the Invention

With the above technique, the barrier is formed from a different material from the one that makes up the organic EL elements. Therefore, the formation of an organic EL display panel entails an additional step of forming the barrier, which makes the manufacturing process more complicated.

Since the barrier releases outgas that can deteriorate the organic EL elements, the amount of outgas increases and has more influences on the organic EL elements if the barrier is formed taller.

It is an object of the present invention to provide a solution for solving the problems encountered, which include the above-described problems.

According to a first aspect of the present invention, there is provided an organic electroluminescent display panel that includes a substrate, a first display electrode formed on the main face of the substrate, and an organic functional layer formed on the first display electrode. The first display electrode has one or more pixel light-emitting regions. The organic functional layer has at least one organic material layer. The organic electroluminescent display panel also includes a mask spacer provided near the organic functional layer, and a second display electrode formed on the organic functional layer. The mask spacer is made of the same material as any one of the organic material layers and has a top face located higher than the position of the second display electrode, when measured from the main face of the substrate.

According to a second aspect of the present invention, there is provided a method for manufacturing an organic electroluminescent display panel. This organic electroluminescent display panel includes a substrate, a first display electrode formed on the main face of the substrate and having one or more pixel light-emitting regions, an organic functional layer that is formed on the first display electrode and has at least one organic material layer, a mask spacer provided near the organic functional layer, and a second display electrode formed on the organic functional layer. The display panel manufacturing method includes the steps of forming the first display electrode on the main face of the substrate, forming the organic functional layer on the first display electrode, and forming the second display electrode on the organic functional layer. The step of forming the organic functional layer includes forming the mask spacer, which is made of the same material as any one of the organic material layers and has a top face located higher than the top face of the second display electrode, when measured from the main face of the substrate.

### Brief Description of the Drawings

FIG. 1A and 1B are partial cross sectional views of the organic EL display panel according to one embodiment of the present invention;
FIG. 2 is a partial cross sectional view of a modification to the organic EL display panel shown in FIG.1;
FIG. 3 is a partial cross sectional view of another modification to the organic EL display panel shown in FIG.1;
FIG. 4 is a partial cross sectional view of still another modification to the organic EL display panel shown in FIG. 1;
FIG. 5A to FIG. 5D is a series of partial cross sectional views useful to explain a method for manufacturing an organic EL display panel according to the present invention;
FIG. 6A to FIG. 6C is a series of partial cross sectional views of the manufacturing method subsequent to FIG. 5D;
FIG. 7A to FIG. 7D is a series of partial cross sectional views useful to explain a modification to the organic EL display panel manufacturing method according to the present invention; and
FIG. 8A to FIG. 8D is a series of partial cross sectional views to explain a modification to the organic EL display panel manufacturing method according to the present invention.

### Mode for Carrying Out the Invention

The organic EL display panel, and the method for manufacturing this panel, according to embodiments of the present invention will now be described in detail with reference to the accompanying drawings.

### Embodiment 1

As shown in FIG. 1A, an organic EL display panel 1 has a substrate 2 made of glass, resin, or the like and a first display electrode 3 made of an electroconductive material such as indium tin oxide (hereinafter referred to as ITO) and provided on the main face of the substrate 2. The first display electrode 3 may be disposed so as to form a striped or other pattern.

A plurality of pixel light-emitting regions 4 are formed in the first display electrode 3 provided on the substrate 2, and a first thin-film piece 5 is disposed in each of the pixel light-emitting regions 4. This group of first thin-film pieces forms a first functional layer 6. The first functional layer is composed of at least one organic material layer, and may, for example, be composed of a hole injection layer. When the first functional layer is made of a material with a low molecular weight, it may be formed by vapor deposition or another such dry process. When the first functional layer is made of a material with a high molecular weight or another such organic material that is soluble or can be dispersed in a solvent, it may be formed by inkjet method, spin coating; printing, or another such wet process.

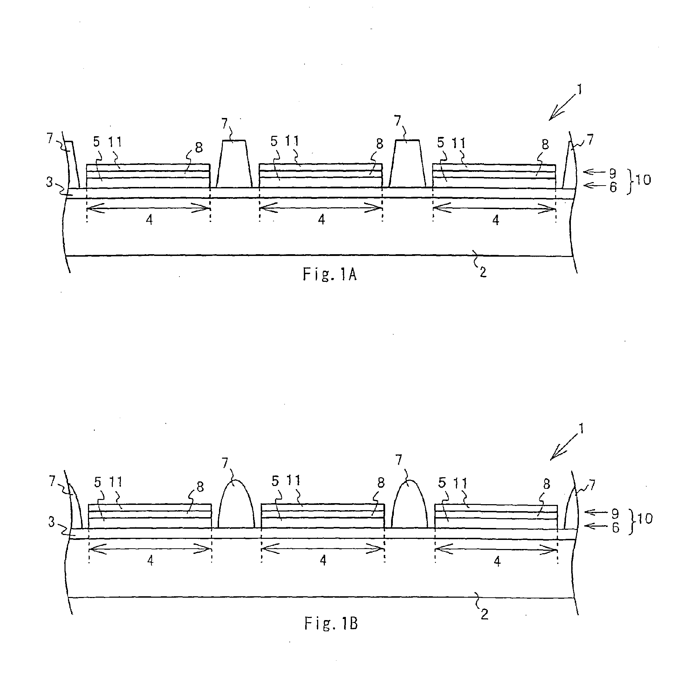

Mask spacers 7 made of the same material as the first functional layer 6 are formed between adjacent pixel light-emitting regions 4. The mask spacers 7 have a top face that is located higher than the top face of a second display electrode (discussed below), when measured from the main face of the substrate 2. When formed by a film formation method in which a thin film that constitutes an organic EL element, such as a second functional layer or second display electrode (discussed below), is used as a mask, the mask spacers 7 can serve as spacers between the substrate and the mask. The cross sectional shape of the mask spacers is not limited to the trapezoidal shape shown in FIG. 1A, and a variety of shapes are possible, such as a semi-elliptical shape (FIG. 1B), an inverted trapezoidal shape, or a vertical shape. The thickness of the mask spacers 7 may be greater than the thickness of the first functional layer 6 in the pixel light-emitting regions 4.

A second thin-film piece 8 is provided on each of the first thin-film pieces 5. This group of second thin-film pieces forms a second functional layer 9. The second functional layer 9 may include at least one organic material layer. For example, the second functional layer 9 includes a hole transport layer, a light emitting layer, and an electron transport layer which are stacked in that order. Thus, the second thin-film pieces 8 may each be formed by stacking a thin-film piece constituting a hole transport layer, a thin-film piece constituting a light emitting layer, and a thin-film piece constituting an electron transport layer in that order, for example. The second thin-film pieces 8 may include a light emitting material suited to emitting red (R), green (G), and blue (B) light. The first functional layer may also be a three-color (RGB) common layer. A laminate of the first and second functional layers 6 and 9 thus constitute an organic functional layer 10.

A second display electrode 11 is provided on the organic functional layer 10. The second display electrode 11 is disposed, for example, so as to form a striped pattern that is at a right angle to the first display electrode 3. The portions where the first and second display electrodes 3 and 11 intersect form the light emitting portions of the organic EL display panel 1. The organic EL display panel 1 constituted in this way may include a sealing film (not shown) or a sealing can (not shown) for sealing the first display electrode 3, the organic functional layer 10, and the second display electrode 11, so that the organic EL elements are shielded from the atmosphere.

With an organic EL display panel constituted as above, the generation of outgas can be suppressed because the mask spacers are formed using the material of the organic functional layer that makes up the organic EL elements. Also, by providing the mask spacers, damage to and fouling of the organic functional layer and other thin films by contact can be prevented because the mask is prevented from coming into contact with these thin films during their formation.

The organic material layer of the organic functional layer that is made of the same material as that of the mask spacers is not limited to being the first functional layer on the first display electrode. For instance, the mask spacers may be formed from the same material as a second functional layer of the organic functional layer. When the organic functional layer has first, second, and third functional layers, the mask spacers may be made of the same material as the first and third functional layers, or may be made of the same material as the second functional layer. Thus, when the organic functional layer is composed of a plurality of organic material layers, the mask spacers may be made of the same material as any one or more of these organic functional layers.

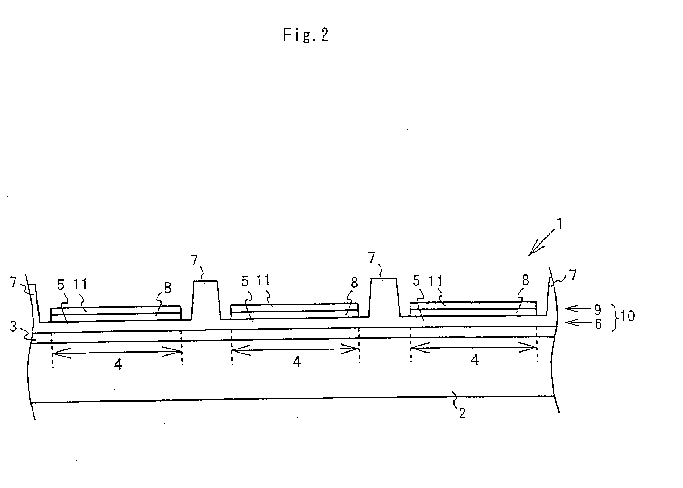

The mask spacers may be contiguous with one or more of the organic functional layers. For instance, as shown in FIG. 2, the organic EL display panel 1 is configured such that the first and second functional layers 6 and 9 are formed on the first display electrode 3, and the first functional layer 6 is contiguous with the mask spacers 7.

The mask spacers are not limited to being provided between adjacent pixel light-emitting regions, and may be formed, for example, around the boundary of the display region where a plurality of organic EL elements of the organic EL display panel are provided.

### Embodiment 2

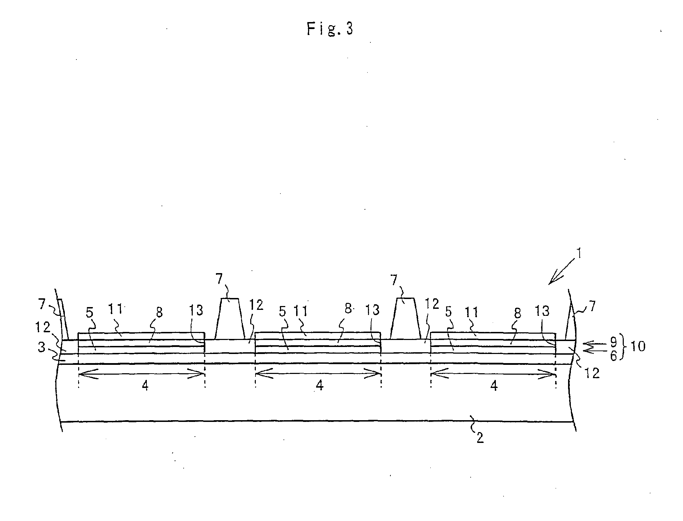

FIG. 3 illustrates a modification to the above-described organic EL display panel. As shown in FIG. 3, the organic EL display panel 1 may be configured such that insulating films 12 are provided on the first display electrode 3. A plurality of windows 13 are formed in the insulating films 12, and these windows 13 expose the first display electrode 3 and demarcate the pixel light-emitting regions 4. The insulating films 12 are made of an organic material such aspolyimide, or an inorganic material such as silicon oxide. The insulating films may be made of a material with poor wettability.

First thin-film pieces 5 made of an organic material having a hole injection function, for example, are disposed in the pixel light-emitting regions 4 demarcated by the insulating films 12, thereby forming a first functional layer 6. Mask spacers 7 are provided on the insulating films 12, and these mask spacers 7 are made of the same material as the first functional layer 6 provided in the pixel light-emitting regions 4. The mask spacers 7 have a top face located higher than the position where the second display electrode (discussed below) is to be formed, when viewed from the main face of the substrate 2. The thickness of the mask spacers 7 may be greater than the thickness of the first functional layer 6 in the pixel light-emitting regions 4.

A second thin-film piece 8 made of an organic material having a light emitting function is provided on each of the first thin-film pieces 5, thereby forming a second functional layer 9. The second thin-film pieces 8 may include an organic light emitting material suited to emitting red (R), green (G), and blue (B) light. The first functional layer 6 and the second functional layer 9 thus constitute an organic functional layer 10. A second display electrode 11 made of an electroconductive material is provided on the second thin-film pieces 8.

With an organic EL display panel constituted as described above, providing the mask spacers on the insulating films can effectively prevent contact between the masks and the thin films because the substrate and the masks are farther apart.

### Embodiment 3

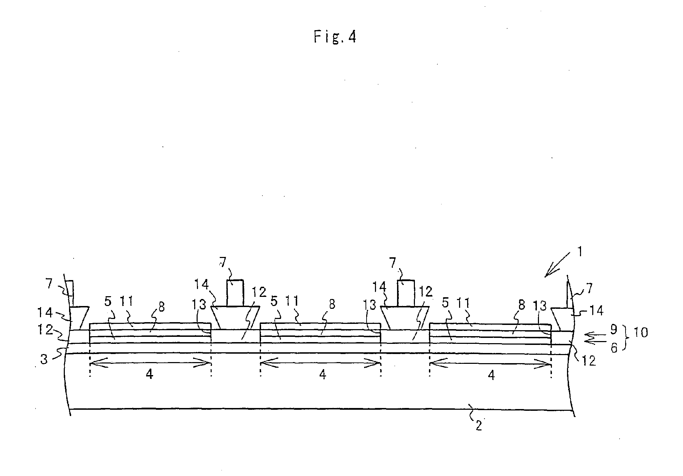

An embodiment will be described in which barriers separating adjacent second display electrodes are provided in the organic EL display panel. As shown in FIG. 4, the organic EL display panel 1 is configured such that a first display electrode 3 having electrode pieces disposed in a striped pattern, for example, is provided on the main face of the substrate 2. Insulating films 12 that demarcate the pixel light-emitting regions 4 are provided on the first display electrode 3. A plurality of barriers 14 extending (or protruding) from the main face of the substrate 2 are provided on the insulating films 12. The barriers 14 have at their upper part an overhang that protrudes parallel to the substrate, and may have a cross sectional shape that is inverted trapezoidal, for example. The barriers 14 may be made of a resin material. The barriers may be made of a material with poor wettability. The insulating films 12 may be omitted, and the barriers 14 may be formed directly on the first display electrode 3.

A first thin-film piece 5 is provided to each of the pixel light-emitting regions 4 on the first display electrode 3. This group of first thin-film pieces forms the first functional layer 6. The first thin-film pieces 5 may be formed by inkjet method, spin coating, or another such wet process, for example. Mask spacers 7 made of the same material as the first functional layer 6 are formed at the upper part of the barriers 14. The mask spacers 7 have a top face that is located higher than the position of a second display electrode (discussed below), when viewed from the main face of the substrate. The thickness of the mask spacers 7 may be greater than the thickness of the first functional layer 6 in the pixel light-emitting regions 4.

A second thin-film piece 8 made of an organic material having a light emitting function and other functions is provided on each of the first thin-film pieces 5. This group of second thin-film pieces forms a second functional layer 9, and the first and second functional layers 6 and 9 form the organic functional layer 10. Each of the second thin-film pieces 8 of the second functional layer 9 may include an organic light emitting material suited to emitting three-color (RGB) light, for example.

A second display electrode 11 is provided on each of the second thin-film pieces 8, and adjacent second display electrodes 11 are separated by barriers 14.

With an organic EL display panel constituted as described above, even though the barriers are low in height, the mask spacers allow the top faces of the mask spacers to be higher than the location of the second display electrodes. That is, the organic functional layer or other thin films will come into contact with the masks when the degree of parallelism between the masks and the substrate is low, or when the bumps and undulations of the masks are large, as compared to the height of the barriers, but the distance between the masks and the substrate can be increased by forming the mask spacers on the barriers, and therefore contact effectively prevented. Also, even if the height of barriers is lowered, and the volume of the barriers reduced, in order to reduce the amount of outgas released by the barriers, contact between the organic functional layer or the second display electrode and the masks can be effectively prevented by providing the mask spacers on the barriers.

### Embodiment 4

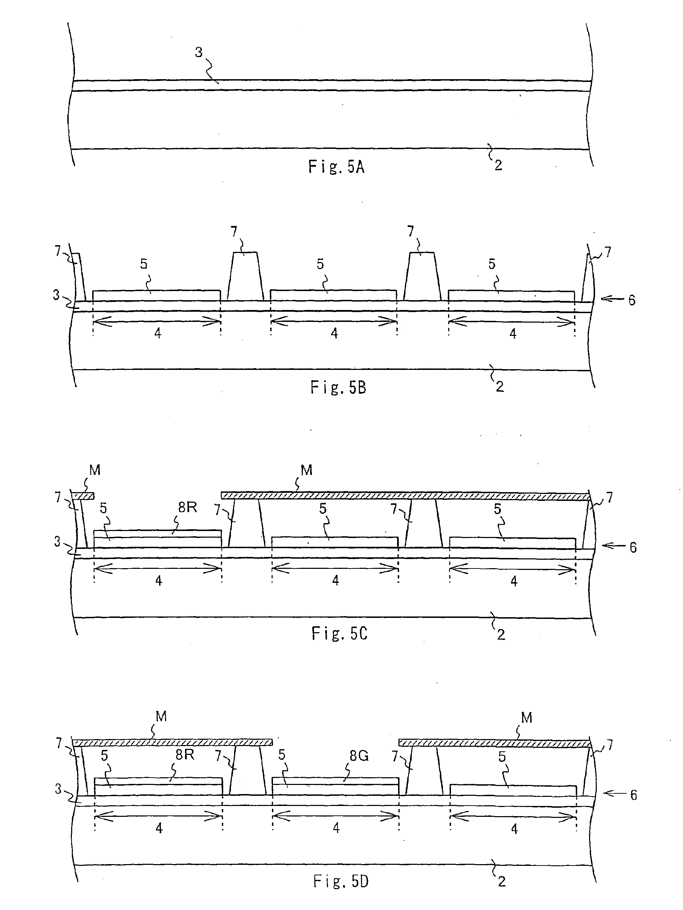

The method for manufacturing an organic EL display panel constituted as in Embodiment 1 will now be described. An ITO or other conductive material film is formed by sputtering or another such film formation method on the main face of a substrate 2 made of glass or a resin. A photoresist is made in a specific pattern on this conductive material film, and etching is then performed. After this etching, the resist is removed to form the first display electrode 3 (FIG. 5A).

After the first display electrode 3 has been formed, as shown in FIG. 5B, the first functional layer 6 is formed by providing a first thin-film piece 5 to each of the pixel light-emitting regions 4 on the first display electrode 3. A film formation method that involves an inkjet process, for example, can be used to form the first functional layer 6.

In the step of producing the first functional layer 6, a step is also performed in which mask spacers 7 having a top face located higher than the position where the second display electrode is to be formed, when viewed from the main face of the substrate 2, are formed from the same material as the first functional layer. For example, when the first functional layer is formed by an inkjet method, the mask spacers 7 are formed by increasing the supply amount of solution containing the material that makes up the first functional layer between adjacent pixel light-emitting regions, over the supply amount within the pixel light-emitting regions. The thickness of the mask spacers 7 may be greater than the thickness of the first functional layer 6 in the pixel light-emitting regions 4.

After the first functional layer 6 has been formed, second thin-film pieces made of an organic material having a light emitting function and other functions are formed on the first thin-film pieces 5. Masked vapor deposition can be employed, for example, to form the second thin-film pieces. Masked vapor deposition is performed by placing a mask over the mask spacers, and using this mask to block the flow of the vapor deposited material. This group of second thin-film pieces forms a second functional layer, and the first and second functional layers form the organic functional layer.

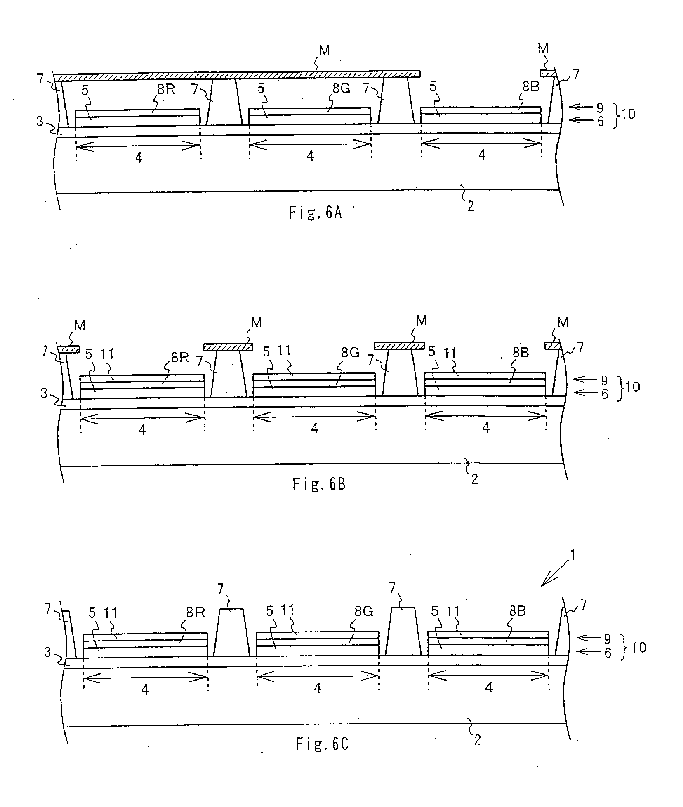

The second thin-film pieces may include an organic light emitting material suited to emitting red (R), green (G), and blue (B) light, for example. For instance, a mask M having a certain opening pattern is placed over the mask spacers 7 and a red organic light emitting material is vapor deposited to form second thin-film pieces 8R (FIG. 5C), after which the position of the opening of this mask M is changed, and the vapor deposition of a green organic light emitting material is performed (FIG. 5D). After the second thin-film pieces 8G have been formed, the position of the opening of this mask M is changed, and the vapor deposition of a blue organic light emitting material is performed to form second thin-film pieces 8B (FIG. 6A).

As discussed above, providing the mask spacers makes it less likely that the masks will come into contact with the first and second functional layers. Thus, it is less likely that there will be defects in the organic functional layer caused by mask contact. As a result, it is less likely that there will be electrode short-circuiting at such defects.

After the second functional layer 9 has been formed, a second display electrode 11 made of an electroconductive material such as an aluminum alloy is formed by masked vapor deposition or another such film formation method (FIG. 6B). Masked vapor deposition is performed by placing the mask M over the mask spacers 7. The second display electrode 11 and the mask M are unlikely to come into contact because the top face of the mask spacers 7 is located higher than the top face of the second display electrode 11, when measured from the main face of the substrate 2.

Going through the above steps yields an organic EL display panel 1 having organic EL elements in which the organic functional layer 10 is sandwiched between the first and second display electrodes 3 and 11 (FIG. 6C). After the second display electrode has been formed, a sealing film (not shown) may be formed by sputtering or another such film formation method for sealing the organic EL elements, or a sealing can (not shown) may be disposed for this same purpose.

As discussed above, providing mask spacers made of the same material as the organic material layer allows the mask spacers to be formed along with the organic functional layer, and this reduces the number of steps entailed in the display panel manufacturing process. Also, because there is no need to form barriers made of a material different from that of the organic functional layer, the generation of outgas that would otherwise deteriorate the organic EL elements can be prevented.

The above description of the manufacturing method was for a case in which the organic functional layer made of the same material as the mask spacers was a first functional layer, but the present invention is not limited to this. In the formation of any organic material layer in an organic functional layer having a plurality of organic material layers, mask spacers may be formed using the same material as the organic material layer concerned.

Also, when the first functional layer is composed of a plurality of organic material layers, mask spacers composed of a plurality of thin films may be formed by performing a step in which the amount of solution discharged from an inkjet nozzle is increased, or a step in which a film is formed by printing, for example, every time an organic material layer is formed. The mask spacers shown in FIG. 2 may be formed, for example, by continuously discharging solution from an inkjet nozzle in an inkjet method, and increasing the amount of solution directed to the locations where the mask spacers are to be formed.

The mask spacers may also be formed by a dry process. For instance, the mask spacers may be formed by vapor depositing the same material as that of the first functional layer, using a mask having an opening that corresponds to the pattern of the mask spacers.

### Embodiment 5

A modification to the above-described method for manufacturing an organic EL display panel will be described with reference to FIG. 7A to FIG. 7D. As shown in FIG. 7A, a first display electrode 3 is formed on the main face of a substrate 2 by sputtering or another such film formation method. Subsequently, insulating films 12 are formed on the first display electrode 3. The insulating films 12 have a plurality of windows 13, and these windows 13 expose the first display electrode and demarcate pixel light-emitting regions 4. The insulating films 12 may be made of an organic material such as polyimide. The insulating films 12 are preferably made of a material with poor wettability.

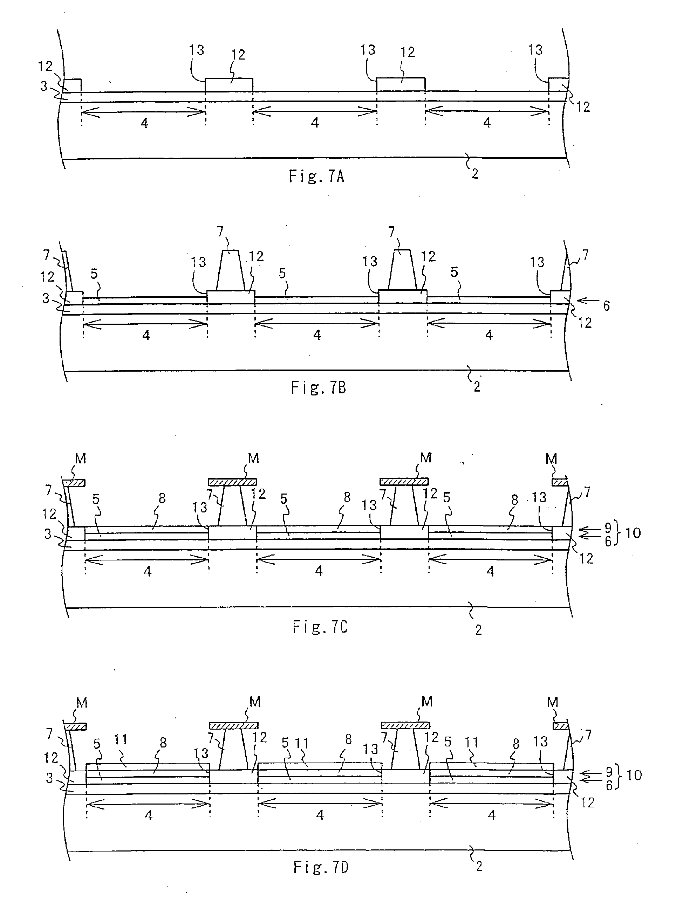

A first thin-film piece 5 is disposed in each of the pixel light-emitting regions 4 to form a first functional layer 6 (FIG. 7B). The first thin-film pieces 5 may be formed by a wet process. For instance, the first thin-film pieces 5 may be formed by applying a solution containing the material that makes up the first functional layer 6 onto the first display electrode by spin coating. If the insulating films 12 have poor wettability, the solution will clump in the pixel light-emitting regions 4 demarcated by the insulating films 12 and form the first thin-film pieces 5 in these regions. Also, because of the poor wettability of the insulating films 12, the solution placed on the insulating films 12 is repelled and does not completely wet the surface. As a result, the mask spacers 7 are formed in a thickness that is greater than the thickness of the first functional layer 6 in the pixel light-emitting regions 4 on the insulating films 12, that is, the thickness of the first thin-film pieces 5. Wettability, the distance between pixel light-emitting regions, and other such factors are controlled so that the top face of the mask spacers 7 will be located higher than the position where the second display electrode (discussed below) is to be formed, when viewed from the main face of the substrate 2.

The step of producing the first functional layer 6 and the mask spacers 7 may involve the use of a wet process such as an inkjet method or printing.

Second thin-film pieces 8 made of an organic material having a light emitting function and other functions are formed on the first thin-film pieces 5 (FIG. 7C). Masked vapor deposition is performed by placing a mask M over the mask spacers 7. This group of second thin-film pieces forms the second functional layer 9.

The second thin-film pieces 8 may include an organic light emitting material suited to emitting red (R), green (G), and blue (B) light, for example. Vapor deposition of a red organic light emitting material, a green organic light emitting material, and a blue organic light emitting material is performed by changing the location of the mask opening.

After the second functional layer 9 has been formed, a second display electrode 11 made of an electroconductive material is formed by masked vapor deposition or the like on the second thin-film pieces 8 (FIG. 7D). Masked vapor deposition is performed by placing a mask M over the mask spacers 7. This forms the second display electrode 11 and completes the manufacturing of the organic EL display panel 1.

With the above-described method for manufacturing an organic EL display panel, mask spacers can be formed by utilizing the wettability of the insulating films in the step of producing the organic functional layer.

The first functional layer and the mask spacers may also be formed by a dry process. For instance, they may be formed by using vapor deposition or another film formation step involving the use of a mask having an opening pattern corresponding to the locations where the mask spacers are to be formed, such as between adjacent pixel light-emitting regions.

### Embodiment 6

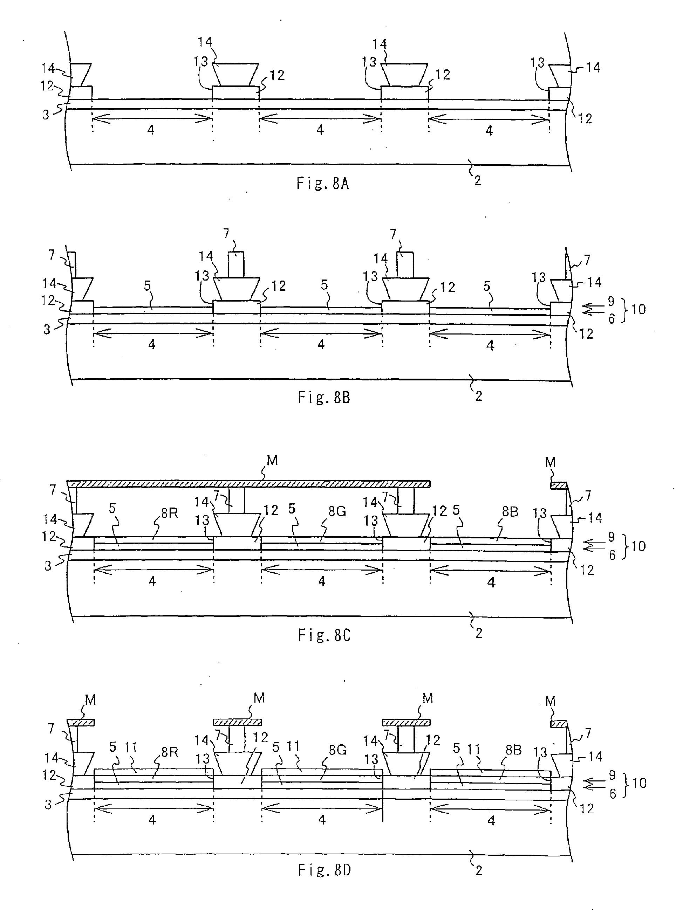

Another modification to the above-described method for manufacturing an organic EL display panel will be described. As shown in FIG. 8A, a first display electrode 3 is formed on the main face of a substrate 2 by sputtering or another such film formation method. After that, insulating films 12 having windows 13 that demarcate pixel light-emitting regions 4 are formed on the first display electrode 3. CVD or another such film formation method is employed in the formation of the insulating films 12, for example. After the insulating films 12 have been formed, for example, a photoresist is put in place, and then this photoresist is exposed through a photomask in which a specific pattern has been formed, and this product is developed to form barriers 14. The barriers 14 preferably have poor wettability with respect to a solution containing the material that makes up the first functional layer (discussed below).

After the barriers 14 have been provided, first thin-film pieces 5 are formed on the pixel light-emitting regions 4 by a wet process such as spin coating, for example, thereby forming the first functional layer 6 (FIG. 8B). In the formation of the first functional layer 6, this solution may also be disposed at the upper part of the barriers 14. If the barriers 14 have poor wettability and the solution is disposed at the upper part of the barriers 14, it will be repelled and will not completely wet the surface, and clumps of solution in the form of balls, for example, will form at the upper part of the barriers 14. These clumps of solution solidify into the mask spacers 7. The mask spacers 7 may also be formed by applying solution on the barriers 14 by printing, inkjet method, or another such process and then solidifying the solution. The top face of the mask spacers 7 is preferably located higher than the position where the top face of the second display electrode (discussed below), when measured from the main face of the substrate 2. If the mask spacers are formed by a dry process, the material that makes up the first functional layer may be disposed over the barriers by using a mask having an opening that corresponds to the pattern of the barriers. The thickness of the mask spacers 7 may be greater than the thickness of the first functional layer 6 in the pixel light-emitting regions 4.

Second thin-film pieces made of an organic material having a light emitting function are formed on the first thin-film pieces 5 by masked vapor deposition or another such method. This group of second thin-film pieces forms the second functional layer. When masked vapor deposition is used, the barriers 14 and the mask spacers 7 serve as spacers between the mask M and the substrate 2. The second thin-film pieces may include an organic light emitting material suited to emitting red (R), green (G), and blue (B) light, for example. For instance, the opening of a mask in which holes have been made in a specific pattern is aligned with the opening in the recesses formed by adjacent barriers, after which this mask is placed on the mask spacers, and a red organic light emitting material is vapor deposited to form second thin-film pieces 8R. The position of the opening in the mask is shifted by a distance corresponding to an interval of barriers, for example, and a green organic light emitting material is vapor deposited to form second thin-film pieces 8G. After the second thin-film pieces 8G have been formed, the position of the opening in the mask may be shifted by an interval of barriers, and a blue organic light emitting material is vapor deposited to form second thin-film pieces 8B (FIG. 8C).

A second display electrode 11 is formed on the second thin-film pieces of the second functional layer 9 by masked vapor deposition or another such film formation method (FIG. 8D). Masked vapor deposition is performed by placing the mask M over the mask spacers 7. The second display electrode 11 is formed, which completes the formation of the organic EL display panel 1.

The above-described manufacturing method reduces teh volume of the barriers. Therefore, the amount of outgas released by the barriers can be reduced, and deterioration of the organic EL display panel is thereby prevented. Also, even though barrier volume is reduced so that the top face of these barriers is located lower than the top face of the organic functional layer, when measured from the main face of the substrate 2, providing the mask spacers on the barriers effectively prevents contact between the mask and the second display electrode or the organic functional layer. Example of Manufacturing Organic EL Display Panel

An organic EL display panel constituted as above was produced by the following procedure.

### (1) Formation of first electrode (anode)

An ITO film with a thickness of 150 nm was formed on the main face of a glass substrate by sputtering. Next, a photoresist (AZ6112, made by Tokyo Ohka) was applied on this ITO film, after which the resist was exposed and developed to form a striped resist pattern. The substrate was immersed in a mixture of hydrochloric acid and a ferric chloride aqueous solution (used as an etchant for the ITO), and the portion of the ITO film not covered by the resist was etched. After this etching treatment, the substrate was immersed in acetone to remove the resist. The ITO film thus obtained had a striped pattern composed of 480 lines, with a line width of 120 µm and a gap width of 10 µm (130 µm pitch). This ITO film served as the first display electrode.

### (2) Formation of insulating film

A polyimide solution (PIX-1400, made by Hitachi Kasei) was applied by spin coating on the substrate on which the first display electrode had been formed. This substrate was heated with a hot plate to evaporate the solvent and form a polyimide precursor film. A photoresist (AZ6112, made by Tokyo Ohka) was then applied on this polyimide precursor film to form a resist film, after which this resist film was exposed using a photomask having a pattern corresponding to the pixel light-emitting regions of an organic EL display panel. After exposure, the resist was developed. In the developing of this resist film, the portion of the polyimide film not covered by the resist film with a specific pattern was also dissolved in the developing solution, so that etching of the polyimide precursor film was carried out at the same time. After developing, the substrate was immersed in acetone to remove the resist, which created a polyimide precursor film pattern that demarcated the pixel light-emitting regions by covering the ends of the first display electrode. The first display electrode was exposed in the pixel light-emitting regions. This polyimide precursor film became imide by being heated to 300°C, an insulating film pattern made of polyimide was obtained.

### (3) Formation of first functional layer and mask spacers

A hole injection material solution (made by Nissan Chemical Industries) was applied by spin coating on the insulating films and first display electrode. The unnecessary portion of the spin coated film was wiped away with acetone. This substrate was heated with a hot plate to evaporate the solvent and form a first functional layer composed of a hole injection material film of approximately 35nm in the pixel light-emitting regions. The hole injection material solution applied on the insulating films was repelled and did not wet the surface because of the poor wettability of the insulating films. Thus, the hole injection material film pieces were formed in a thickness greater than the thickness of the first functional layer in the pixel light-emitting regions. The hole injection material film pieces thus obtained serve as mask spacers.

### (4) Formation of second functional layer and second display electrode (cathode)

A second functional layer was formed by forming films of α-NPD (45 nm) and Alq₃ (60 nm), in that order, by masked vapor deposition on the first functional layer composed of the hole injection material film. A mask was disposed on the mask spacers in this masked vapor deposition.

A metal thin film made of an aluminum-lithium (Al-Li) alloy was formed in a thickness of 100 nm by masked vapor deposition on the substrate on which the second functional layer had been formed. This vapor deposition was performed by applying a mask with a striped pattern composed of 120 lines, with a line width of 250 µm and a gap of 140 µm (390 µm pitch), over the mask spacers and then directing vapor deposition material flow of an Al-Li alloy at the main face of the substrate in a substantially perpendicular direction. The metal thin film formed on the second functional layer became the second display electrode, and the second display electrode thus formed had a striped pattern composed of 120 lines. An organic EL element group comprising a simple matrix of 480 x 120 pixels was formed on the substrate by forming the second display electrode.

### (5) Sealing

After the formation of the second display electrode, a glass sheet that had a recessed portion and to which a drying agent had been applied to this recessed portion was bonded with a UV-setting adhesive to the substrate to which the organic EL element group had been provided, thereby sealing the organic EL element group. Going through the above-described steps yielded an organic EL display panel with which various displays can be performed with 480 x 120 dots in a single green color. With this organic EL display panel, no defective pixels attributable to damage to the organic functional layer or the second display electrode were seen.

In step (3), the first functional layer and the mask spacers can be formed by applying the hole injection material solution by flexo-printing rather than spin coating. This method also yields an organic EL display panel without defective pixels.

In the embodiments and examples given above, the description was of using mask spacers to prevent a vapor deposition mask from coming into contact with the thin films, but the mask spacers of the present invention are also useful when no vapor deposition mask is used. For instance, when the organic functional layer is formed by separate coating with inkjet process, a divider called a bank is formed to prevent the ink discharged from the inkjet from flowing into the pixel light-emitting regions (see Japanese Patent No. 3,328,297, for example). The mask spacers discussed above can perform the role of such a bank.

## Claims

1. An organic electroluminescent display panel comprising:
a substrate having a main face;
a first display electrode formed on the main face of the substrate and having one or more pixel light-emitting regions;
an organic functional layer that is formed on the first display electrode and includes at least one organic material layer;
a mask spacer provided near the organic functional layer; and
a second display electrode formed on the organic functional layer;
wherein the mask spacer is made of the same material as any one of the organic material layers and has a top face located higher than a position of the second display electrode, when measured from the main face of the substrate.

2. The organic electroluminescent display panel according to Claim 1, wherein a thickness of the mask spacer is greater than a thickness at the pixel light-emitting region of any one of the organic material layers.

3. The organic electroluminescent display panel according to Claim 1 or 2, wherein the mask spacer is provided between each two adjacent ones of said pixel light-emitting regions.

4. The organic electroluminescent display panel according to Claim 3, further comprising an insulating film that demarcates the pixel light-emitting regions on the first display electrode, wherein the mask spacer is provided on the insulating film.

5. The organic electroluminescent display panel according to Claim 1 or 2, further comprising a barrier that is supported by the first display electrode and separates adjacent said second display electrodes, wherein the mask spacer is provided on the barrier.

6. A method for manufacturing an organic electroluminescent display panel including a substrate, a first display electrode formed on a main face of the substrate and having one or more pixel light-emitting regions, an organic functional layer that is formed on the first display electrode and has at least one organic material layer, a mask spacer provided near the organic functional layer, and a second display electrode formed on the organic functional layer, comprising the steps of:
forming the first display electrode on the main face of the substrate;
forming the organic functional layer on the first display electrode; and
forming the second display electrode on the organic functional layer,
wherein the step of forming the organic functional layer includes a step of forming the mask spacer, which is made of the same material as any one of the organic material layers and has a top face located higher than the position of the second display electrode, when measured from the main face of the substrate.

7. The method for manufacturing an organic electroluminescent display panel according to Claim 6, wherein the thickness of the mask spacer is greater than the thickness at the pixel light-emitting region of any one of the organic material layers.

8. The method for manufacturing an organic electroluminescent display panel according to Claim 6 or 7,
wherein the mask spacer is provided between each two adjacent said pixel light-emitting regions.

9. The method for manufacturing an organic electroluminescent display panel according to Claim 8, further comprising a step of forming an insulating film that demarcates the pixel light-emitting regions on the first display electrode, between the step of forming the first display electrode and the step of forming the organic functional layer, wherein the step of forming the mask spacer is a step of providing the mask spacer on the insulating film.

10. The method for manufacturing an organic electroluminescent display panel according to Claim 6 or 7, further comprising a step of providing a barrier that is supported by the first display electrode and separates adjacent said second display electrodes, between the step of forming the first display electrode and the step of forming the organic functional layer,
wherein the step of forming the mask spacer is a step of providing the mask spacer on the barrier.

11. The method for manufacturing an organic electroluminescent display panel according to Claim 6 or 7, wherein the step of forming the mask spacer includes spin coating.

12. The method for manufacturing an organic electroluminescent display panel according to Claim 6 or 7, wherein the step of forming the mask spacer includes an inkjet process.

13. The method for manufacturing an organic electroluminescent display panel according to Claim 6 or 7, wherein the step of forming the mask spacer includes printing.
